# EUROPEAN PATENT SPECIFICATION

(11) **EP 4 502 547 B1**
(45) Date of publication and mention of the grant of the patent: **04.11.2026**
(21) Application number: 24184291.3
(22) Date of filing: 25.06.2024
(51) Int. Cl.: G01D 11/24

(54) **WATERPROOF ZHAGA SENSOR HAVING GROUP-CONTROLLED FUNCTION**
WASSERDICHTER ZHAGA-SENSOR MIT GRUPPENGESTEUERTER FUNKTION
CAPTEUR ZHAGA ÉTANCHE À L'EAU AYANT UNE FONCTION COMMANDÉE PAR GROUPE

(30) Priority: 03.08.2023 CN 202310973168
(43) Date of publication of application: 05.02.2025
(73) Proprietor: Xiamen PVTECH Co., Ltd., Xiamen, Fujian 361101 (CN)
(72) Inventor: HONG, HAIBO, Xiamen, 361101 (CN); LU, FUXING, Xiamen, 361101 (CN)
(74) Representative: Lang, Christian

(56) References cited:
- CN-U- 209 589 125
- CN-U- 211 262 263
- JP-A- 2012 063 328

## Description

### TECHNICAL FIELD

The present invention relates to a sensor, in particular to a waterproof Zhaga sensor having group-controlled function.

### BACKGROUND

In order to meet the requirements of IoT systems and other intelligent systems, the functions of sensors has undergone significant improvements and optimizations. Zhaga interface has been applied to LED lighting devices, making sensors compliant with the Zhaga standard a current development trend. However, currently available Zhaga sensors lack an effective waterproof structure. Therefore, when a Zhaga sensor are placed in a humid environment, the circuit board of the Zhaga sensor is prone to damage due to contact with water, rendering the Zhaga sensor unable to operate properly.

Document JP 2012 063328 A teaches a waterproof sensor design having an operation mode dip switch, which comprises: a housing having an upper opening and a switch hole; an upper cover disposed on the upper opening to cover the upper opening; a first circuit board disposed inside the housing; a dip switch disposed on the first circuit board and corresponding to the switch hole; a second circuit board disposed on the first circuit board and a switch hole sealing pad disposed on the switch hole to cover the switch hole. Document CN 211 315 886 U discloses a sensor having a group-controlled dip switch, comprising: a housing having an upper opening, a lower opening and a switch hole; an upper cover disposed on the upper opening to cover the upper opening; a first circuit board disposed inside the housing; a dip switch disposed on the first circuit board and corresponding to the switch hole; and a plurality of metal pins disposed at the lower opening and electrically connected to the first circuit board.

### SUMMARY

The present invention provides a waterproof Zhaga sensor having group-controlled function according to claim 1, which includes a housing, an upper cover, a first circuit board, a group-controlled dip switch, a second circuit board, a plurality of metal pins and a switch hole sealing pad. The housing has an upper opening, a lower opening, and a switch hole. The upper cover is disposed on the upper opening to cover the upper opening. The first circuit board is disposed inside the housing. The group-controlled dip switch is disposed on the first circuit board and corresponding to the switch hole. The second circuit board is disposed on the first circuit board. The metal pins are disposed at the lower opening to form a Zhaga interface and electrically connected to the first circuit board. The switch hole sealing pad is disposed on the switch hole to cover the switch hole.

The switch hole has a waterproof ring disposed on the side wall of the switch hole. The waterproof ring has a first protruding ring and a second protruding ring. The first protruding ring extends in a direction away from the switch hole to form a first waterproof groove between the first protruding ring and the side wall of the switch hole, and the second protruding ring extends in a direction toward a central axis of the switch hole to form a second waterproof groove between the first protruding ring and the second protruding ring. Furthermore, the switch hole sealing pad has a first sealing ring embedded in the first waterproof groove and a second sealing ring embedded in the second waterproof groove.

In one embodiment, the switch hole sealing pad further includes a waterproof fixing ring disposed on the bottom of the switch hole sealing pad to form a first waterproof space between the first sealing ring and the second sealing ring, and form a second waterproof space between the second sealing ring and the waterproof fixing ring. The first protruding ring is embedded in the first waterproof space and the second protruding ring is embedded in the second waterproof space.

In one embodiment, the diameter of the switch hole decreases along a first direction parallel to the central axis of the switch hole and facing the central point of the housing.

In one embodiment, the waterproof Zhaga sensor further includes an upper sealing pad disposed between the upper cover and the housing.

In one embodiment, the second circuit board is a Bluetooth module, a WiFi module, a ZigBee module or other similar components.

In one embodiment, the waterproof Zhaga sensor having group-controlled function further includes a third circuit board and a fourth circuit board disposed on the first circuit board.

In one embodiment, the third circuit board is a microwave module and the fourth circuit board is a light sensing module.

In one embodiment, the number of the metal pins are two or more.

The waterproof Zhaga sensor having the group-controlled function in accordance with the embodiments of the present invention may have the following advantages:
(1) In the present invention, the waterproof Zhaga sensor having group-controlled function includes a housing, an upper cover, a first circuit board, a group-controlled dip switch, a second circuit board, a plurality of metal pins and a switch hole sealing pad. The housing has an upper opening, a lower opening, and a switch hole. The upper cover is disposed on the upper opening to cover the upper opening. The first circuit board is disposed inside the housing. The group-controlled dip switch is disposed on the first circuit board and corresponding to the switch hole. The second circuit board is disposed on the first circuit board. The metal pins are disposed at the lower opening to form a Zhaga interface and electrically connected to the first circuit board. The switch hole sealing pad is disposed on the switch hole to cover the switch hole. As described above, as the waterproof Zhaga sensor has the group-controlled dip switch, the waterproof Zhaga sensor can provide the group-controlled function so as to meet the requirements of different applications.
(2) In the present invention, the switch hole of the housing of the waterproof Zhaga sensor has a waterproof ring on the side wall thereof. The waterproof ring includes a first protruding ring and a second protruding ring. The first protruding ring extends in the direction away from the switch hole to form a first waterproof groove between the first protruding ring and the side wall of the switch hole. The second protruding ring extends in the direction toward the central axis of the switch hole to forming a second waterproof groove between the first and second protruding rings. Additionally, the switch hole sealing pad of the waterproof Zhaga sensor has a first sealing ring and a second sealing ring. The first sealing ring is embedded in the first waterproof groove, while the second sealing ring is embedded in the second waterproof groove. The waterproof Zhaga sensor has the waterproof ring, which can provide two waterproof grooves, and the switch hole sealing pad has two corresponding sealing rings, such that the switch hole sealing pad can be engaged with the water proof ring, thereby providing a double-layer waterproof structure (the first waterproof layer and the second waterproof layer). This structural design significantly enhances the waterproof function of the waterproof Zhaga sensor, so the waterproof Zhaga sensor can operate reliably for a long time even in humid environments.
(3) In one embodiment of the present invention, the switch hole sealing pad of the waterproof Zhaga sensor further includes a waterproof fixing ring. The waterproof fixing ring is disposed on the bottom of the switch hole sealing pad to form a first waterproof space between the first sealing ring and the second sealing ring, and form a second waterproof space between the second sealing ring and the waterproof fixing ring. The first protruding ring is embedded in the first waterproof space, and the second protruding ring is embedded in the second waterproof space. Therefore, the switch hole sealing pad additionally provides two waterproof spaces, reinforcing the waterproof structure to form a double-layer waterproof structure (the third waterproof layer and the fourth waterproof layer). Furthermore, the waterproof fixing ring can serve as a bottom sealing structure. The aforementioned design further enhances the waterproof effect of the waterproof Zhaga sensor, so the waterproof Zhaga sensor can operate reliably for a long time even in humid environments.
(4) In one embodiment of the present invention, the diameter of the switch hole of the housing of the waterproof Zhaga sensor decreases along a first direction. The first direction is parallel to the central axis of the switch hole and faces the central point of the housing. In other words, the side wall of the switch hole is inclined. The above structural design prevents water from easily entering the interior of the housing, effectively preventing damage to the waterproof Zhaga sensor. As a result, the reliability of the waterproof Zhaga sensor can be significantly improved so as to meet actual requirements.
(5) In one embodiment of the present invention, the waterproof Zhaga sensor further includes an upper cover sealing pad. The upper cover sealing pad is disposed between the upper cover and the housing. The upper cover sealing pad effectively enhances the waterproof effect between the upper cover and the housing. The above design further strengthens the waterproof function of the waterproof Zhaga sensor, such that the waterproof Zhaga sensor can operate reliably for a long time even in humid environments.
(6) In one embodiment of the present invention, the waterproof Zhaga sensor further includes a second circuit board, which can be a Bluetooth module, a WiFi module, a ZigBee module, or other similar component. Therefore, the waterproof Zhaga sensor can provide not only the group-controlled function but also other intelligent functions. Consequently, the waterproof Zhaga sensor can be more flexible in use.
(7) In one embodiment of the present invention, the waterproof Zhaga sensor further includes a third circuit board and a fourth circuit board. The third circuit board can be a microwave module, while the fourth circuit board can be a light sensing module. Therefore, the waterproof Zhaga sensor can also provide microwave sensing and light sensing functions. Consequently, the use of the waterproof Zhaga sensor becomes more flexible so as to conform to the requirements of different intelligent applications.

Further scope of applicability of the present application will become more apparent from the detailed description given hereinafter. However, it should be understood that the detailed description and specific examples, while indicating exemplary embodiments of the present invention, are given by way of illustration only, since various changes and modifications within the scope of the present invention will become apparent to those skilled in the art from this detailed description.

### BRIEF DESCRIPTION OF THE DRAWINGS

The present invention will become more fully understood from the detailed description given herein below and the accompanying drawings which are given by way of illustration only, and thus are not limitative of the present invention and wherein:
FIG. 1 is an exploded view of a waterproof Zhaga sensor having group-controlled function in according with one embodiment of the present invention.
FIG. 2 is a perspective view of the waterproof Zhaga sensor having group-controlled function in according with one embodiment of the present invention.
FIG. 3 is a bottom view of the waterproof Zhaga sensor having group-controlled function in according with one embodiment of the present invention.
FIG. 4 is a schematic view of the waterproof Zhaga sensor having group-controlled function in according with one embodiment of the present invention.
FIG. 5 is a sectional view of the waterproof Zhaga sensor having group-controlled function in according with one embodiment of the present invention.
FIG. 6 is a partial enlargement view of the waterproof Zhaga sensor having group-controlled function in according with one embodiment of the present invention.
FIG. 7 is an exploded view of a waterproof Zhaga sensor having group-controlled function in according with another embodiment of the present invention.
FIG. 8 is a perspective view of the waterproof Zhaga sensor having group-controlled function in according with another embodiment of the present invention.
FIG. 9 is a bottom view of the waterproof Zhaga sensor having group-controlled function in according with another embodiment of the present invention.
FIG. 10 is a bottom view of a first circuit board of the waterproof Zhaga sensor having group-controlled function in according with another embodiment of the present invention.

### DETAILED DESCRIPTION

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing. It should be understood that, when it is described that an element is "coupled" or "connected" to another element, the element may be "directly coupled" or "directly connected" to the other element or "coupled" or "connected" to the other element through a third element. In contrast, it should be understood that, when it is described that an element is "directly coupled" or "directly connected" to another element, there are no intervening elements.

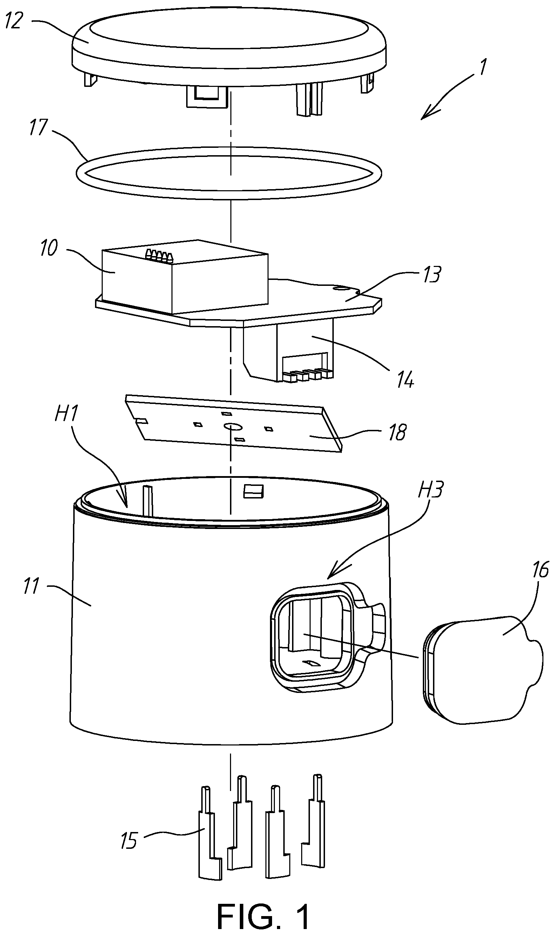

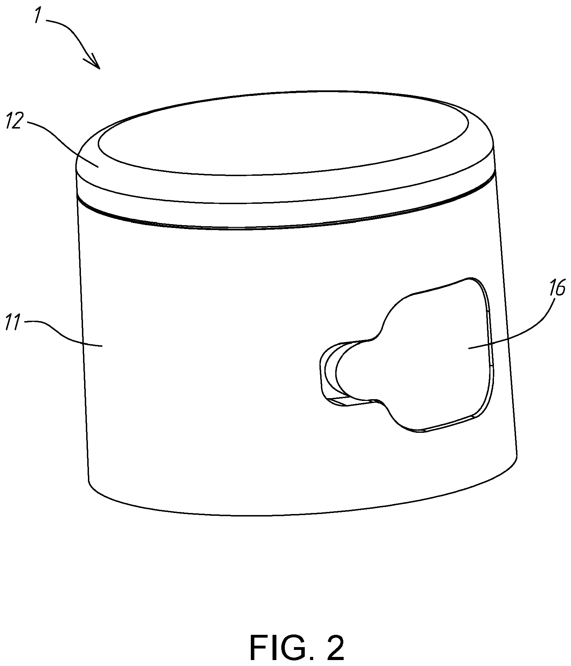

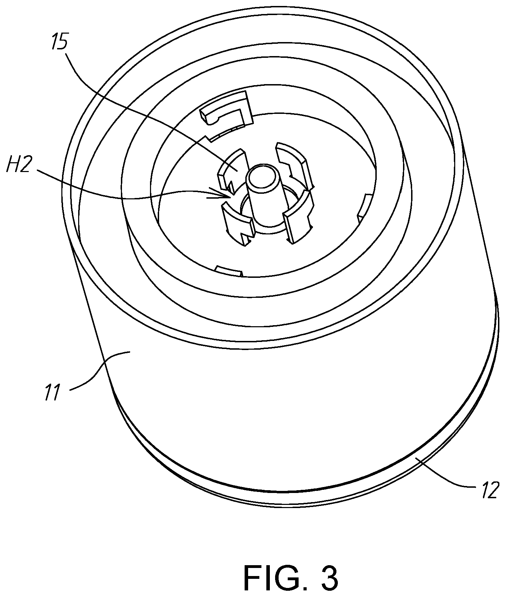

Please refer to FIG. 1, FIG. 2 and FIG. 3, which are an exploded view, a perspective view and a bottom view of a waterproof Zhaga sensor having group-controlled function in according with one embodiment of the present invention respectively. As shown in FIG. 1, FIG, 2 and FIG. 3, the Zhaga sensor 1 includes a housing 11, an upper cover 12, a first circuit board 13, a second circuit board 18, a group-controlled dip switch 14, a plurality of metal pins 15, a switch hole sealing pad 16, an upper cover sealing pad 17, and a power module 10.

The housing 11 has an upper opening H1, a lower opening H2, and a switch hole H3. The shape of the housing 11 can be cylindrical. In another embodiment, the shape of the housing 11 can be changed according to actual requirements. In one embodiment, the housing 11 can be made of a metal material or a plastic material.

The upper cover 12 is disposed on the upper opening H1 to cover the upper opening H1. In one embodiment, the upper cover is made of a transparent material or a translucent material, such as glass or plastics.

The upper cover sealing pad 17 is disposed between the upper cover 12 and the housing 11. The upper cover sealing pad 17 can effectively enhance the waterproof effect between the upper cover 12 and the housing 11 in order to strengthen the waterproof function of the Zhaga sensor 1. In one embodiment, the upper cover sealing pad 17 can be made of silicone, rubber, or other elastic materials.

The first circuit board 13 is disposed inside the housing 11. The power module 10 and other necessary circuit components can be disposed on the upper surface of the first circuit board 13. In one embodiment, the first circuit board 13 can be a printed circuit board, a flexible circuit board, or other similar components.

The group-controlled dip switch 14 is disposed on the first circuit board 13 and is electrically connected to the first circuit board 13, such that the position of the group-controlled dip switch 14 can be corresponding to that of the switch hole H3. In this embodiment, the group-controlled dip switch 14 can be disposed on the lower surface of the first circuit board 13, such that the position of the group-controlled dip switch 14 can be corresponding to that of the switch hole H3.

The second circuit board 18 can be disposed on the upper surface of the first circuit board 13 and is electrically connected to the first circuit board 13. In this embodiment, the second circuit board 18 is a Bluetooth module. In another embodiment, the second circuit board 18 can also be a WiFi module, a ZigBee module, or similar components. Due to the presence of the second circuit board 18, the waterproof sensor 1 can provide various intelligent functions so as to increase the flexibility thereof in use.

The metal pins 15 are disposed at the lower opening H2 and are electrically connected to the first circuit board 13 (and the electronic components on the first circuit board 13, such as the power module 10). The metal pins 15 form a Zhaga interface. In one embodiment, the material of the multiple metal pins 15 can be copper, aluminum, or other metal materials. In another embodiment, the surface of the metal pins 15 may have a metal coating, such as nickel. In one embodiment, the number of the metal pins 15 is two or more (in this embodiment, the number of the metal pins 15 is four).

The switch hole sealing pad 16 is disposed on the switch hole H3 to cover the switch hole H3. In one embodiment, the switch hole sealing pad 16 can be made of silicone, rubber, or other elastic materials.

The embodiment just exemplifies the present invention and is not intended to limit the scope of the present invention; any equivalent modification and variation according to the present invention is to be also included within the scope of the following claims and their equivalents.

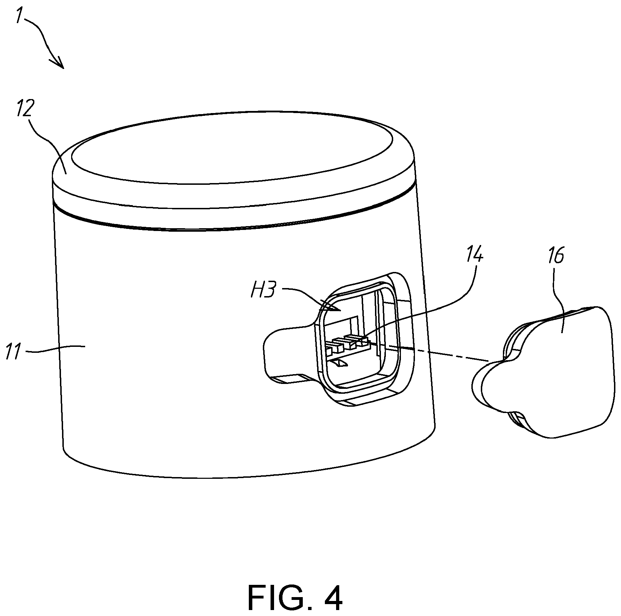

Please refer to FIG. 4, which is a schematic view of the waterproof Zhaga sensor having group-controlled function in according with one embodiment of the present invention. As shown FIG. 4, the user can remove the switch hole sealing pad 16 to expose the group-controlled dip switch 14 from the switch hole H3. Then, the user can operate the group-controlled dip switch 14 to set and execute the group-controlled functions.

As set forth above, the waterproof Zhaga sensor 1 has the group-controlled dip switch 14 to provide the group-controlled function so as to meet the requirements of different applications. Therefore, the application of the waterproof Zhaga sensor 1 can be more comprehensive.

The embodiment just exemplifies the present invention and is not intended to limit the scope of the present invention; any equivalent modification and variation according to the present invention is to be also included within the scope of the following claims and their equivalents.

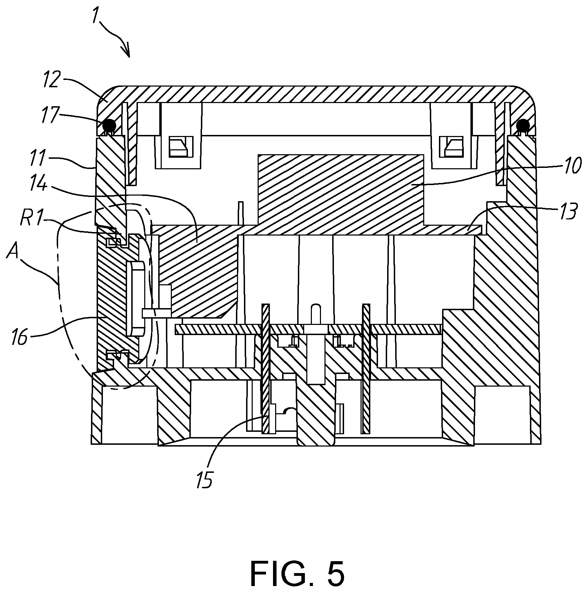

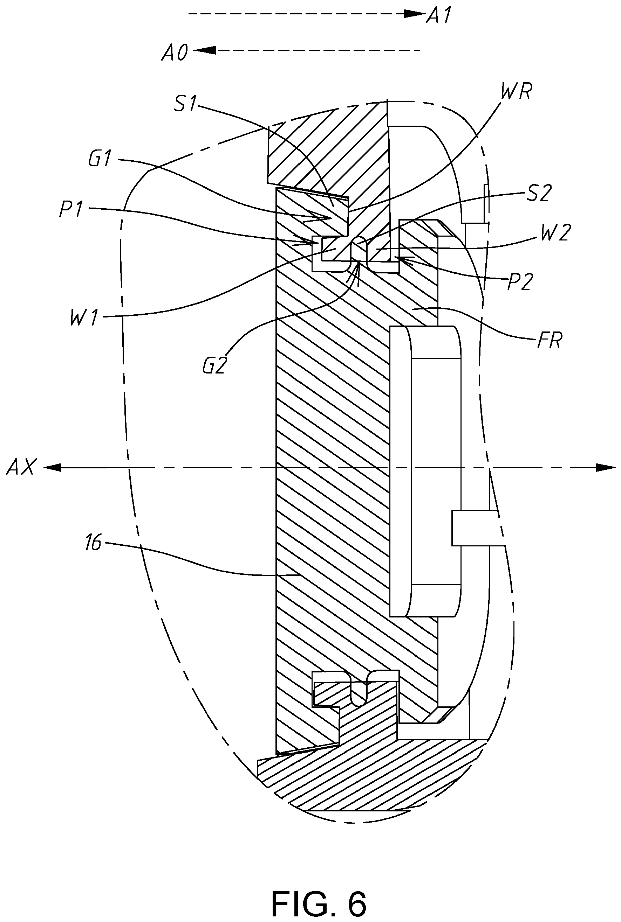

Please refer to FIG. 5 and FIG. 6, which are a sectional view and a partial enlargement view of the waterproof Zhaga sensor having group-controlled function in according with one embodiment of the present invention respectively. FIG. 6 shows the enlarged view of the marked area A in FIG. 5. As shown in FIG. 5 and FIG. 6, the switch hole H3 has a waterproof ring WR on the side wall thereof. The waterproof ring WR has a first protruding ring W1 and a second protruding ring W2. The first protruding ring W1 extends in the direction away from the switch hole H3 to form a first waterproof groove G1 between the first protruding ring W1 and the side wall of the switch hole H3. The second protruding ring W2 extends in the direction toward the central axis AX of the switch hole H3 to form a second waterproof groove G2 between the first and second protruding rings W1 and W2. In addition, the switch hole sealing pad 16 has a first sealing ring S1 and a second sealing ring S2. The first sealing ring S1 is embedded in the first waterproof groove G1, and the second sealing ring S2 is embedded in the second waterproof groove G2.

Through the above structure, the switch hole sealing pad 16 can be engaged with the waterproof ring WR, such that the switch hole sealing pad 16 can provide a first waterproof layer (the first sealing ring S1 embedded in the first waterproof groove G1) and a second waterproof layer (the second sealing ring S2 embedded in the second waterproof groove G2) with a view to forming a double-layer waterproof structure.

Furthermore, the switch hole sealing pad 16 also has a waterproof fixing ring FR. The waterproof fixing ring FR is disposed on the bottom of the switch hole sealing pad 16. In this way, the first sealing ring S1 and the second sealing ring S2 form the first waterproof space P1. The second sealing ring S2 and the waterproof fixing ring FR form the second waterproof space P2. The first protruding ring W1 is embedded in the first waterproof space P1, and the second protruding ring W2 is embedded in the second waterproof space P2. Thus, the switch hole sealing pad 16 can additionally provide two waterproof spaces to serve as a reinforced waterproof structure so as to form a third waterproof layer (the first protruding ring W1 embedded in the first waterproof space P1) and a fourth waterproof layer (the second protruding ring W2 embedded in the second waterproof space P2) in order to form a double-layer waterproof structure. Additionally, the waterproof fixing ring FR can serve as a bottom sealing structure.

From the above, the switch hole H3 of the housing 11 of the waterproof Zhaga sensor 1 has the waterproof ring WR disposed on the side wall thereof. The waterproof ring WR includes the first protruding ring W1 and the second protruding ring W2. The first protruding ring W1 extends in the direction away from the switch hole H3 to form the first waterproof groove G1 between the first protruding ring W1 and the side wall of the switch hole H3. The second protruding ring W2 extends in the direction toward the central axis AX of the switch hole H3 to form the second waterproof groove G2 between the first and second protruding rings W1 and W2. Furthermore, the switch hole sealing pad 16 of the waterproof Zhaga sensor 1 has the first sealing ring S1 and the second sealing ring S2. The first sealing ring S1 is embedded in the first waterproof groove G1, and the second sealing ring S2 is embedded in the second waterproof groove G2. Therefore, the waterproof Zhaga sensor 1 has the waterproof ring WR that provides two waterproof grooves, while the switch hole sealing pad 16 has two corresponding sealing rings. Thus, the switch hole sealing pad 16 can be engaged with the waterproof ring WR so as to provide the double-layer waterproof structure (the first waterproof layer and the second waterproof layer). Additionally, the switch hole sealing pad 16 of the waterproof Zhaga sensor 1 also has the waterproof fixing ring FR. The waterproof fixing ring FR is disposed on the bottom of the switch hole sealing pad 16, so the first sealing ring S1 and the second sealing ring S2 can form the first waterproof space P1. The second sealing ring S2 and the waterproof fixing ring FR can form the second waterproof space P2. The first protruding ring W1 is embedded in the first waterproof space P1 and the second protruding ring W2 is embedded in the second waterproof space P2. Thus, the switch hole sealing pad 16 can additionally provide two waterproof spaces to serve as the reinforced waterproof structure so as to form the double-layer waterproof structure (the third waterproof layer and the fourth waterproof layer). The waterproof fixing ring FR can also serve as the bottom sealing structure.

The above structural design significantly enhances the waterproof function of the waterproof Zhaga sensor 1, so the waterproof Zhaga sensor 1 can operate normally for a long time even in humid environments.

Additionally, the diameter of the switch hole H3 of the housing 11 of the waterproof Zhaga sensor 1 decrease along the first direction (as shown by the arrow A1 shown in FIG. 6). The first direction is parallel to the central axis AX of the switch hole H3 and faces the central point of the housing 11. In other words, the side wall of the switch hole H3 is inclined. This structural design makes it difficult for water to enter the interior of the housing 11, effectively preventing damage to the waterproof Zhaga sensor 1. Therefore, the reliability of the waterproof Zhaga sensor 1 can be significantly improved so as to conform to actual requirements.

The embodiment just exemplifies the present invention and is not intended to limit the scope of the present invention; any equivalent modification and variation according to the present invention is to be also included within the scope of the following claims and their equivalents.

It is worthy to point out that currently available Zhaga sensors lack an effective waterproof structure. Therefore, when a Zhaga sensor are placed in a humid environment, the circuit board of the Zhaga sensor is prone to damage due to contact with water, rendering the Zhaga sensor unable to operate properly. By contrast, according to one embodiment of the present invention, the waterproof Zhaga sensor having the group-controlled function includes a housing, an upper cover, a first circuit board, a group-controlled dip switch, a second circuit board, a plurality of metal pins and a switch hole sealing pad. The housing has an upper opening, a lower opening, and a switch hole. The upper cover is disposed on the upper opening to cover the upper opening. The first circuit board is disposed inside the housing. The group-controlled dip switch is disposed on the first circuit board and corresponding to the switch hole. The second circuit board is disposed on the first circuit board. The metal pins are disposed at the lower opening to form a Zhaga interface and electrically connected to the first circuit board. The switch hole sealing pad is disposed on the switch hole to cover the switch hole. As described above, as the waterproof Zhaga sensor has the group-controlled dip switch, the waterproof Zhaga sensor can provide the group-controlled function so as to meet the requirements of different applications.

According to one embodiment of the present invention, the switch hole of the housing of the waterproof Zhaga sensor has a waterproof ring on the side wall thereof. The waterproof ring includes a first protruding ring and a second protruding ring. The first protruding ring extends in the direction away from the switch hole to form a first waterproof groove between the first protruding ring and the side wall of the switch hole. The second protruding ring extends in the direction toward the central axis of the switch hole to forming a second waterproof groove between the first and second protruding rings. Additionally, the switch hole sealing pad of the waterproof Zhaga sensor has a first sealing ring and a second sealing ring. The first sealing ring is embedded in the first waterproof groove, while the second sealing ring is embedded in the second waterproof groove. The waterproof Zhaga sensor has the waterproof ring, which can provide two waterproof grooves, and the switch hole sealing pad has two corresponding sealing rings, such that the switch hole sealing pad can be engaged with the water proof ring, thereby providing a double-layer waterproof structure (the first waterproof layer and the second waterproof layer). This structural design significantly enhances the waterproof function of the waterproof Zhaga sensor, so the waterproof Zhaga sensor can operate reliably for a long time even in humid environments.

According to one embodiment of the present invention, the switch hole sealing pad of the waterproof Zhaga sensor further includes a waterproof fixing ring. The waterproof fixing ring is disposed on the bottom of the switch hole sealing pad to form a first waterproof space between the first sealing ring and the second sealing ring, and form a second waterproof space between the second sealing ring and the waterproof fixing ring. The first protruding ring is embedded in the first waterproof space, and the second protruding ring is embedded in the second waterproof space. Therefore, the switch hole sealing pad additionally provides two waterproof spaces, reinforcing the waterproof structure to form a double-layer waterproof structure (the third waterproof layer and the fourth waterproof layer). Furthermore, the waterproof fixing ring can serve as a bottom sealing structure. The aforementioned design further enhances the waterproof effect of the waterproof Zhaga sensor, so the waterproof Zhaga sensor can operate reliably for a long time even in humid environments.

Also, according to one embodiment of the present invention, the diameter of the switch hole of the housing of the waterproof Zhaga sensor decreases along a first direction. The first direction is parallel to the central axis of the switch hole and faces the central point of the housing. In other words, the side wall of the switch hole is inclined. The above structural design prevents water from easily entering the interior of the housing, effectively preventing damage to the waterproof Zhaga sensor. As a result, the reliability of the waterproof Zhaga sensor can be significantly improved so as to meet actual requirements.

Further, according to one embodiment of the present invention, the waterproof Zhaga sensor further includes an upper cover sealing pad. The upper cover sealing pad is disposed between the upper cover and the housing. The upper cover sealing pad effectively enhances the waterproof effect between the upper cover and the housing. The above design further strengthens the waterproof function of the waterproof Zhaga sensor, such that the waterproof Zhaga sensor can operate reliably for a long time even in humid environments.

Moreover, according to one embodiment of the present invention, the waterproof Zhaga sensor further includes a second circuit board, which can be a Bluetooth module, a WiFi module, a ZigBee module, or other similar component. Therefore, the waterproof Zhaga sensor can provide not only the group-controlled function but also other intelligent functions. Consequently, the waterproof Zhaga sensor can be more flexible in use.

Furthermore, according to one embodiment of the present invention, the waterproof Zhaga sensor further includes a third circuit board and a fourth circuit board. The third circuit board can be a microwave module, while the fourth circuit board can be a light sensing module. Therefore, the waterproof Zhaga sensor can also provide microwave sensing and light sensing functions. Consequently, the use of the waterproof Zhaga sensor becomes more flexible so as to conform to the requirements of different intelligent applications. As described above, the waterproof Zhaga sensor having group-controlled function according to the embodiments of the present invention can definitely achieve great technical effects.

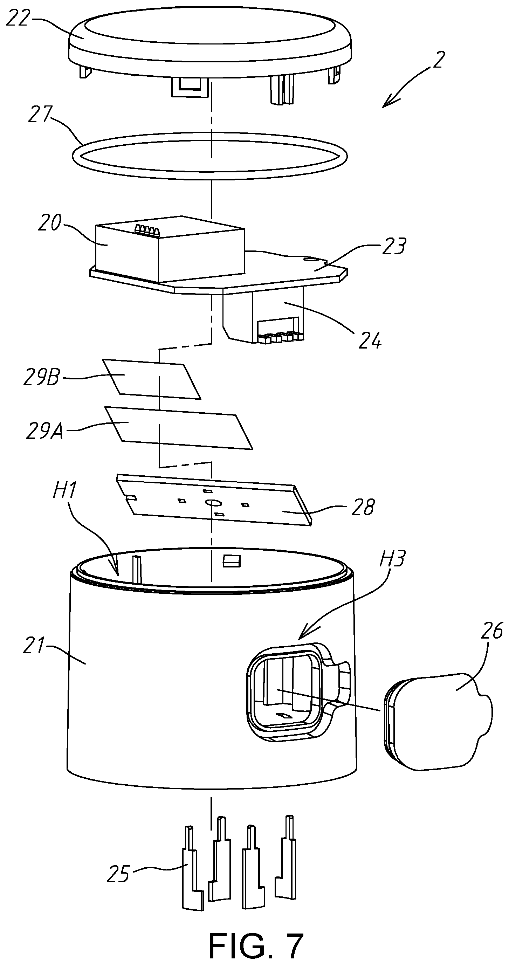

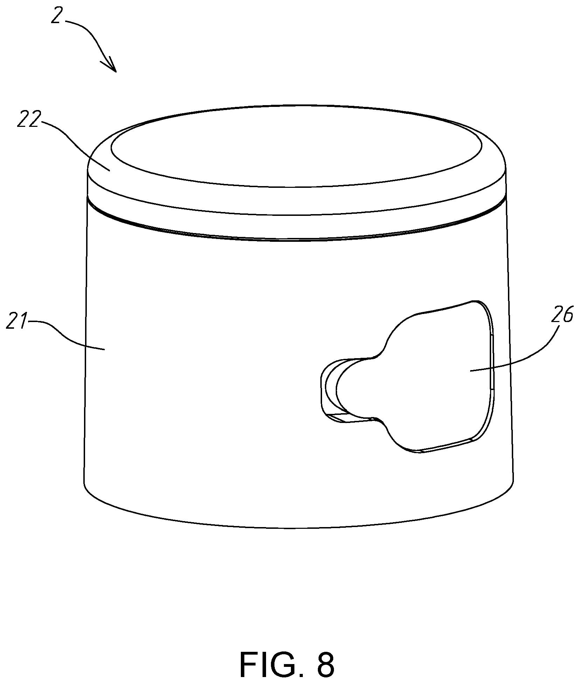

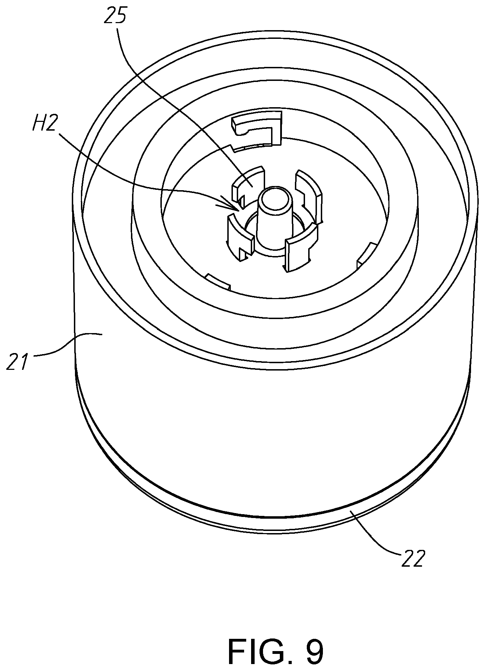

Please refer to FIG. 7, FIG. 8 and FIG. 9, which are an exploded view, a perspective view and a bottom view of a waterproof Zhaga sensor having group-controlled function in according with another embodiment of the present invention respectively. As shown in FIG. 7, FIG. 8 and FIG. 9, the waterproof Zhaga sensor 2 includes a housing 21, an upper cover 22, a first circuit board 23, a second circuit board 28, a group-controlled dip switch 24, a plurality of metal pins 25, a switch hole sealing pad 26, an upper cover sealing pad 27 and a power module 20.

The housing 21 has an upper opening H1, a lower opening H2 and a switch hole H3. The upper cover 22 is disposed on the upper opening H1 to cover the upper opening H1. The upper cover sealing pad 27 is disposed between the upper cover 22 and the housing 21. The first circuit board 23 is disposed inside the housing 21. The power module 20 and other necessary circuit components can be disposed on the upper surface of the first circuit board 23. The group-controlled dip switch 24 is disposed on the first circuit board 23 and corresponds to the switch hole H3; in this embodiment, the group-controlled dip switch 24 can be disposed on the lower surface of the first circuit board 23. The second circuit board 28 can be disposed on the first circuit board 23 and electrically connected to the first circuit board 23. In this embodiment, the second circuit board 28 can be disposed on the lower surface of the first circuit board 23. The metal pins 25 are disposed at the lower opening H2 and electrically connected to the first circuit board 23 (and the electronic components on the first circuit board 23, such as the power module 20). The metal pins 25 can form a Zhaga interface. The switch hole sealing pad 26 is disposed on the switch hole H3 to cover the switch hole H3.

The above elements of this embodiment are similar to those in the previous embodiment, so will not be elaborated herein again. The difference between this embodiment and the previous embodiment is that the waterproof Zhaga sensor 2 further includes a third circuit board 29A and a fourth circuit board 29B.

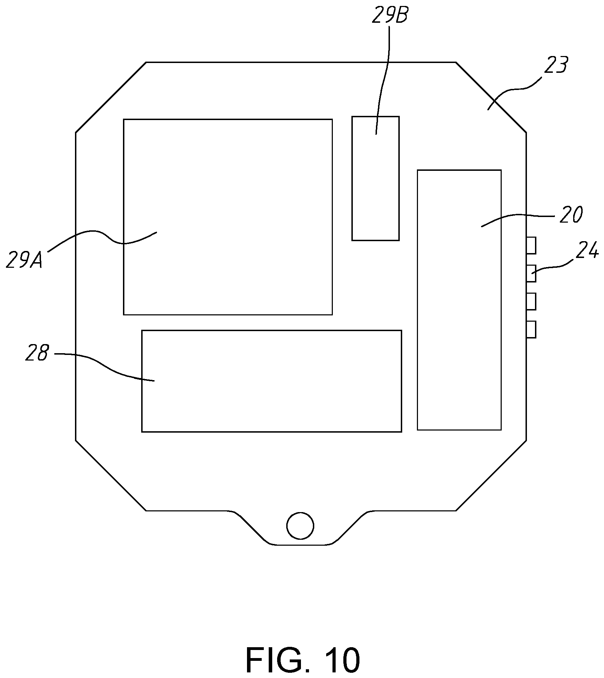

Please refer to FIG. 10, which is a bottom view of a first circuit board of the waterproof Zhaga sensor having group-controlled function in according with another embodiment of the present invention. As shown in FIG. 10, the third circuit board 29A and the fourth circuit board 29B can be disposed on the first circuit board 23. In this embodiment, the third circuit board 29A and the fourth circuit board 29B can be disposed on the lower surface of the first circuit board 23. In this embodiment, the third circuit board 29A is a microwave module, and the fourth circuit board 29B is a light sensing module.

Since the waterproof Zhaga sensor 2 has the third circuit board 29A and the fourth circuit board 29B, the waterproof Zhaga sensor 2 can provide not only group-controlled function but also microwave sensing and light sensing functions. Therefore, the waterproof Zhaga sensor 2 can be more flexible in use.

The embodiment just exemplifies the present invention and is not intended to limit the scope of the present invention; any equivalent modification and variation according to the present invention is to be also included within the scope of the following claims and their equivalents.

To sum up, according to one embodiment of the present invention, the waterproof Zhaga sensor having the group-controlled function includes a housing, an upper cover, a first circuit board, a group-controlled dip switch, a second circuit board, a plurality of metal pins and a switch hole sealing pad. The housing has an upper opening, a lower opening, and a switch hole. The upper cover is disposed on the upper opening to cover the upper opening. The first circuit board is disposed inside the housing. The group-controlled dip switch is disposed on the first circuit board and corresponding to the switch hole. The second circuit board is disposed on the first circuit board. The metal pins are disposed at the lower opening to form a Zhaga interface and electrically connected to the first circuit board. The switch hole sealing pad is disposed on the switch hole to cover the switch hole. As described above, as the waterproof Zhaga sensor has the group-controlled dip switch, the waterproof Zhaga sensor can provide the group-controlled function so as to meet the requirements of different applications.

According to the present invention, the switch hole of the housing of the waterproof Zhaga sensor has a waterproof ring on the side wall thereof. The waterproof ring includes a first protruding ring and a second protruding ring. The first protruding ring extends in the direction away from the switch hole to form a first waterproof groove between the first protruding ring and the side wall of the switch hole. The second protruding ring extends in the direction toward the central axis of the switch hole to forming a second waterproof groove between the first and second protruding rings. Additionally, the switch hole sealing pad of the waterproof Zhaga sensor has a first sealing ring and a second sealing ring. The first sealing ring is embedded in the first waterproof groove, while the second sealing ring is embedded in the second waterproof groove. The waterproof Zhaga sensor has the waterproof ring, which can provide two waterproof grooves, and the switch hole sealing pad has two corresponding sealing rings, such that the switch hole sealing pad can be engaged with the water proof ring, thereby providing a double-layer waterproof structure (the first waterproof layer and the second waterproof layer). This structural design significantly enhances the waterproof function of the waterproof Zhaga sensor, so the waterproof Zhaga sensor can operate reliably for a long time even in humid environments.

According to one embodiment of the present invention, the switch hole sealing pad of the waterproof Zhaga sensor further includes a waterproof fixing ring. The waterproof fixing ring is disposed on the bottom of the switch hole sealing pad to form a first waterproof space between the first sealing ring and the second sealing ring, and form a second waterproof space between the second sealing ring and the waterproof fixing ring. The first protruding ring is embedded in the first waterproof space, and the second protruding ring is embedded in the second waterproof space. Therefore, the switch hole sealing pad additionally provides two waterproof spaces, reinforcing the waterproof structure to form a double-layer waterproof structure (the third waterproof layer and the fourth waterproof layer). Furthermore, the waterproof fixing ring can serve as a bottom sealing structure. The aforementioned design further enhances the waterproof effect of the waterproof Zhaga sensor, so the waterproof Zhaga sensor can operate reliably for a long time even in humid environments.

Also, according to one embodiment of the present invention, the diameter of the switch hole of the housing of the waterproof Zhaga sensor decreases along a first direction. The first direction is parallel to the central axis of the switch hole and faces the central point of the housing. In other words, the side wall of the switch hole is inclined. The above structural design prevents water from easily entering the interior of the housing, effectively preventing damage to the waterproof Zhaga sensor. As a result, the reliability of the waterproof Zhaga sensor can be significantly improved so as to meet actual requirements.

Further, according to one embodiment of the present invention, the waterproof Zhaga sensor further includes an upper cover sealing pad. The upper cover sealing pad is disposed between the upper cover and the housing. The upper cover sealing pad effectively enhances the waterproof effect between the upper cover and the housing. The above design further strengthens the waterproof function of the waterproof Zhaga sensor, such that the waterproof Zhaga sensor can operate reliably for a long time even in humid environments.

Moreover, according to one embodiment of the present invention, the waterproof Zhaga sensor further includes a second circuit board, which can be a Bluetooth module, a WiFi module, a ZigBee module, or other similar component. Therefore, the waterproof Zhaga sensor can provide not only the group-controlled function but also other intelligent functions. Consequently, the waterproof Zhaga sensor can be more flexible in use.

Furthermore, according to one embodiment of the present invention, the waterproof Zhaga sensor further includes a third circuit board and a fourth circuit board. The third circuit board can be a microwave module, while the fourth circuit board can be a light sensing module. Therefore, the waterproof Zhaga sensor can also provide microwave sensing and light sensing functions. Consequently, the use of the waterproof Zhaga sensor becomes more flexible so as to conform to the requirements of different intelligent applications.

It will be apparent to those skilled in the art that various modifications and variations can be made to the disclosed embodiments. It is intended that the specification and examples be considered as exemplary only, with a true scope of the present invention being indicated by the following claims and their equivalents.

## Claims

1. A waterproof Zhaga sensor (1) having group-controlled function, comprising:
a housing (11, 21) having an upper opening (H1), a lower opening (H2), and a switch hole (H3),
wherein the switch hole has a waterproof ring (WR) disposed on a side wall of the switch hole, and
having a first protruding ring (W1) and a second protruding ring (W2), wherein the first protruding ring extends in a direction away from the switch hole to form a first waterproof groove (G1) between the first protruding ring and the side wall of the switch hole, and the second protruding ring extends in a direction toward a central axis of the switch hole to form a second waterproof groove (G2) between the first protruding ring and the second protruding ring;
an upper cover (12, 22) disposed on the upper opening to cover the upper opening;
a first circuit board (13, 23) disposed inside the housing;
a group-controlled dip switch (14, 24) disposed on the first circuit board and corresponding to the switch hole;
a second circuit board (18, 28) disposed on the first circuit board;
a plurality of metal pins (15, 25) disposed at the lower opening to form a Zhaga interface and electrically connected to the first circuit board; and
a switch hole sealing pad (16, 26) disposed on the switch hole to cover the switch hole,
wherein the switch hole sealing pad has a first sealing ring (S1) embedded in the first waterproof groove and a second sealing ring (S2) embedded in the second waterproof groove.

2. The waterproof Zhaga sensor having group-controlled function as claimed in claim 1, **characterized in that** the switch hole sealing pad further comprises a waterproof fixing ring disposed on a bottom of the switch hole sealing pad to form a first waterproof space between the first sealing ring and the second sealing ring, and form a second waterproof space between the second sealing ring and the waterproof fixing ring, wherein the first protruding ring is embedded in the first waterproof space and the second protruding ring is embedded in the second waterproof space.

3. The waterproof Zhaga sensor having group-controlled function y as claimed in claim 1, **characterized in that** a diameter of the switch hole decreases along a first direction parallel to a central axis of the switch hole and facing a central point of the housing.

4. The waterproof Zhaga sensor having group-controlled function as claimed in claim 1, **characterized by** further comprising an upper sealing pad disposed between the upper cover and the housing.

5. The waterproof Zhaga sensor having group-controlled function as claimed in claim 1, **characterized in that** the second circuit board is a Bluetooth module, a WiFi module, or a ZigBee module.

6. The waterproof Zhaga sensor having group-controlled function as claimed in claim 1, **characterized by** further comprising a third circuit board and a fourth circuit board disposed on the first circuit board.

7. The waterproof Zhaga sensor having group-controlled function as claimed in claim 6, **characterized in that** the third circuit board is a microwave module.

8. The waterproof Zhaga sensor having group-controlled function as claimed in claim 6, **characterized in that** the fourth circuit board is a light sensing module.

## Patentansprüche

1. Wasserdichter Zhaga-Sensor (1) mit gruppengesteuerter Funktion, welcher umfasst:
ein Gehäuse (11, 21), das eine obere Öffnung (H1), eine untere Öffnung (H2) und eine Schalteröffnung (H3) aufweist, wobei die Schalteröffnung einen wasserdichten Ring (WR) aufweist, der an einer Seitenwand der Schalteröffnung angeordnet ist, und einen ersten vorstehenden Ring (W1) und einen zweiten vorstehenden Ring (W2) aufweist, wobei sich der erste vorstehende Ring in einer Richtung weg von der Schalteröffnung erstreckt, um eine erste wasserdichte Nut (G1) zwischen dem ersten vorstehenden Ring und der Seitenwand der Schalteröffnung auszubilden, und sich der zweite vorstehende Ring in einer Richtung zu einer Mittelachse der Schalteröffnung erstreckt, um eine zweite wasserdichte Nut (G2) zwischen dem ersten vorstehenden Ring und dem zweiten vorstehenden Ring auszubilden;
eine obere Abdeckung (12, 22), die an der oberen Öffnung angeordnet ist, um die obere Öffnung abzudecken;
eine erste Leiterplatte (13, 23), die im Inneren des Gehäuses angeordnet ist;
ein gruppengesteuerter Dip-Schalter (14, 24), der an der ersten Leiterplatte angeordnet ist und mit der Schalteröffnung korrespondiert;
eine zweite Leiterplatte (18, 28), die an der ersten Leiterplatte angeordnet ist;
eine Vielzahl von Metallstiften (15, 25), die an der unteren Öffnung angeordnet sind, um eine Zhaga-Schnittstelle zu bilden und elektrisch mit der ersten Leiterplatte verbunden sind; und
ein Schalteröffnungsdichtungspad (16, 26), das an der Schalteröffnung angeordnet ist, um die Schalteröffnung abzudecken, wobei das Schalteröffnungsdichtungspad einen ersten Dichtungsring (S1), der in die erste wasserdichte Nut eingebettet ist, und einen zweiten Dichtungsring (S2) aufweist, der in die zweite wasserdichte Nut eingebettet ist.

2. Wasserdichter Zhaga-Sensor mit gruppengesteuerter Funktion nach Anspruch 1, **dadurch gekennzeichnet, dass** das Schalteröffnungsdichtungspad ferner einen wasserdichten Befestigungsring umfasst, der an einer Unterseite des Schalteröffnungsdichtungspads angeordnet ist, um einen ersten wasserdichten Raum zwischen dem ersten Dichtungsring und dem zweiten Dichtungsring auszubilden, und einen zweiten wasserdichten Raum zwischen dem zweiten Dichtungsring und dem wasserdichten Befestigungsring auszubilden, wobei der erste vorstehende Ring in dem ersten wasserdichten Raum eingebettet ist und der zweite vorstehende Ring in dem zweiten wasserdichten Raum eingebettet ist.

3. Wasserdichter Zhaga-Sensor mit gruppengesteuerter Funktion nach Anspruch 1, **dadurch gekennzeichnet, dass** ein Durchmesser der Schalteröffnung entlang einer ersten Richtung abnimmt, die parallel zu einer Mittelachse der Schalteröffnung und einem Mittelpunkt des Gehäuses zugewandt ist.

4. Wasserdichter Zhaga-Sensor mit gruppengesteuerter Funktion nach Anspruch 1, **dadurch gekennzeichnet, dass** dieser ferner ein oberes Dichtungspad umfasst, das zwischen der oberen Abdeckung und dem Gehäuse angeordnet ist.

5. Wasserdichter Zhaga-Sensor mit gruppengesteuerter Funktion nach Anspruch 1, **dadurch gekennzeichnet, dass** die zweite Leiterplatte ein Bluetooth-Modul, ein WiFi-Modul oder ein ZigBee-Modul ist.

6. Wasserdichter Zhaga-Sensor mit gruppengesteuerter Funktion nach Anspruch 1, **dadurch gekennzeichnet, dass** dieser ferner eine dritte Leiterplatte und eine vierte Leiterplatte umfasst, die an der ersten Leiterplatte angeordnet sind.

7. Wasserdichter Zhaga-Sensor mit gruppengesteuerter Funktion nach Anspruch 6, **dadurch gekennzeichnet, dass** die dritte Leiterplatte ein Mikrowellenmodul ist.

8. Wasserdichter Zhaga-Sensor mit gruppengesteuerter Funktion nach Anspruch 6, **dadurch gekennzeichnet, dass** die vierte Leiterplatte ein Lichterfassungsmodul ist.

## Revendications

1. Capteur Zhaga étanche (1) présentant une fonction de contrôle de groupe, comprenant :
un boîtier (11, 21) présentant une ouverture supérieure (H1), une ouverture inférieure (H2) et un trou d'interrupteur (H3), dans lequel le trou d'interrupteur présente une bague étanche (WR) disposée sur une paroi latérale du trou d'interrupteur, et présentant une première bague saillante (W1) et une seconde bague saillante (W2), dans lequel la première bague saillante s'étend dans une direction à l'écart du trou d'interrupteur pour former une première rainure étanche (G1) entre la première bague saillante et la paroi latérale du trou d'interrupteur, et la seconde bague saillante s'étend dans une direction vers un axe central du trou d'interrupteur pour former une seconde rainure étanche (G2) entre la première bague saillante et la seconde bague saillante ;
un couvercle supérieur (12, 22) disposé sur l'ouverture supérieure pour recouvrir l'ouverture supérieure ;
une première carte de circuit imprimé (13,23) disposée à l'intérieur du boîtier ;
un commutateur DIP commandé par groupe (14,24) disposé sur la première carte de circuit imprimé et correspondant au trou d'interrupteur ;
une deuxième carte de circuit imprimé (18, 28) disposée sur la première carte de circuit imprimé ;
une pluralité de broches métalliques (15, 25) disposées au niveau de l'ouverture inférieure et reliées électriquement à la première carte de circuit imprimé ; et
un joint d'étanchéité de trou d'interrupteur (16, 26) disposée sur le trou d'interrupteur pour recouvrir le trou d'interrupteur, dans lequel le joint d'étanchéité de trou d'interrupteur présente une première bague d'étanchéité (S1) encastrée dans la première rainure étanche et une seconde bague d'étanchéité (S2) encastrée dans la seconde rainure étanche.

2. Capteur Zhaga étanche présentant une fonction de contrôle de groupe selon la revendication 1, **caractérisé en ce que** le joint d'étanchéité de trou d'interrupteur comprend en outre une bague de fixation étanche disposée sur une base de joint d'étanchéité de trou d'interrupteur afin de former un premier espace étanche entre la première bague d'étanchéité et la seconde bague d'étanchéité et de former un second espace étanche entre la seconde bague d'étanchéité et la bague de fixation étanche, dans lequel la première bague saillante est intégrée dans le premier espace étanche et la seconde bague saillante est intégrée dans le second espace étanche.

3. Capteur Zhaga étanche présentant une fonction de contrôle de groupe selon la revendication 1, **caractérisé en ce qu'**un diamètre des trous d'interrupteur diminue le long d'une première direction parallèle à un axe central du trou d'interrupteur et faisant face à un point central du boîtier.

4. Capteur Zhaga étanche présentant une fonction de contrôle de groupe selon la revendication 1, **caractérisé en ce qu'**il comprend en outre un joint d'étanchéité supérieur disposé entre le couvercle supérieur et le boîtier.

5. Capteur Zhaga étanche présentant une fonction de contrôle de groupe selon la revendication 1, **caractérisé en ce que** la seconde de circuit imprimé est un module Bluetooth, un module WiFi ou un module ZigBee.

6. Capteur Zhaga étanche présentant une fonction de contrôle de groupe selon la revendication 1, **caractérisé en ce qu'**il comprend en outre une troisième carte de circuit imprimé et une quatrième carte de circuit imprimé disposées sur la première carte de circuit imprimé.

7. Capteur Zhaga étanche présentant une fonction de contrôle de groupe selon la revendication 6, **caractérisé en ce que** la troisième carte de circuit imprimé est un module micro-ondes.

8. Capteur Zhaga étanche présentant une fonction de contrôle de groupe selon la revendication 6, **caractérisé en ce que** la quatrième carte de circuit imprimé est un module de détection de lumière.
